# EUROPEAN PATENT SPECIFICATION

(11) **EP 0 642 989 B1**
(45) Date of publication and mention of the grant of the patent: **21.01.1998**
(21) Application number: 94306505.2
(22) Date of filing: 01.09.1994
(51) Int. Cl.: B65D 81/34, B65D 65/40, B65D 65/42, C23C 14/06

(54) **The use of microwave interactive barrier films for heating and browning**
Verwendung von mikrowelleninteraktiven Sperrfilmen zum Erhitzen und Bräunen
Utilisation de films barrières interagissant avec les micro-ondes pour chauffer et dorer

(30) Priority: 01.09.1993 GB 9318143
(43) Date of publication of application: 15.03.1995
(73) Proprietor: REXAM PACKAGING LIMITED, London SW1X 7NN (GB)
(72) Inventor: Revell, Kenneth Martin, Thetford, Norfolk, IP24 1TP (GB)
(74) Representative: Wain, Christopher Paul

(56) References cited:
- EP-A- 0 437 946
- EP-A- 0 463 180
- EP-A- 0 599 225
- WO-A-82/02687
- GB-A- 2 236 278

## Description

This invention relates to the use of a microwave interactive barrier film as a microwave susceptor to provide heating and browning of a surface adjacent the film. By susceptor we mean a material which, during microwaving, becomes heated to a stable temperature (below its melting or other deterioration point) so as to provide heating of a surface of a product adjacent the film.

A microwave susceptor is a microwave responsive heating device that is used in microwave cooking for browning or crisping the surface of foodstuffs to improve their appearance or texture. In normal microwave cooking without a susceptor, the microwaves penetrate through the hulk of the foodstuff and interact with it (primarily with the water it contains), heating and cooking it by a process akin to "steaming". Since temperatures do not normally significantly exceed the boiling point of water (100°C), the surface of the foodstuff has a relatively bland appearance which is, for some foodstuffs, unacceptable to the consumer who prefers the crisper or browner appearance and texture of a conventionally cooked foodstuff. Use of a susceptor as an adjunct to microwave cooking can overcome this problem, because when the susceptor is exposed to microwave energy, it heats up to a significantly higher temperature (typically greater than 150°C) and this heat is then transferred from the susceptor to the surface of the foodstuff by a combination of radiation, convection and conduction, browning or crisping it. To be efficient, the susceptor must produce sufficient radiant heat to brown the surface of the foodstuff, but must not prevent the microwaves penetrating the bulk of the foodstuff and thoroughly cooking it.

Most foodstuffs are perishable in normal environments, reacting with oxygen and moisture with consequent deterioration in their quality, texture and taste e.g. due to bacteriological degradation. By packaging such foodstuffs in a hermetically sealed container with good barrier to oxygen and moisture, shelf life of the foodstuff under ambient conditions of temperature and humidity can be prolonged, often for several months. Since sensitivity to oxygen and moisture degradation will vary from foodstuff to foodstuff, there is no categorical definition within the food packaging industry of what constitutes a barrier packaging material, but it is generally accepted that in order to give a worthwhile extension of shelf life, adequate for the normal retail distribution chain on most perishable foodstuffs, a barrier packaging material must have a permeability to oxygen of typically less than 5cm³/metre²/24 hours (at 23°C, 50% RH) and a permeability to moisture of typically less than 5 grams/metre²/24 hours (at 38°C, 90% RH).

The growth of the convenience food market has created a requirement for a dual purpose package, which can be used to package the foodstuff prior to use, giving it long shelf life under ambient conditions (i.e. without the need for deep freezing) e.g. in the retail store, home or institutional vending machine, and which can subsequently be used as a receptacle for cooking and browning the foodstuff in a microwave oven prior to consumption.

It is known to produce a microwave susceptor by coating a plastics film, such as a poly(ethylene glycol) terephthalate film (hereinafter referred to by its more common name of polyester film) with a thin layer (typically 0.005 - 0.012 micrometres) of a non-ferromagnetic metal such as aluminium, which can interact with the electrical components of a microwave field to produce heat, and then laminating the aluminium metallised film to another substrate such as paper or board (which serves as a "heat sump", preventing the plastic overheating and distorting or melting when exposed to microwaves). Such susceptor constructions were first described by Seiferth (GB 2046060) and Brasted (US 4267420) and this construction of susceptor, hereinafter referred to as the conventional susceptor, is still the most widely used commercially, for applications ranging from browning discs for pizzas, heating pads to make popcorn "pop", and cartons, packs and wraps for a wide variety of potato, bakery and other foodstuffs requiring a brown or "crisp" surface.

These conventional microwave susceptors have a number of disadvantages in their production and use, e.g:
i) Manufacture of the susceptor requires very precise control of the aluminium deposition. The aluminium only functions as a susceptor over a very narrow range of thickness/surface resistivity. This is made more difficult by the fact that the freshly deposited aluminium layer reacts with oxygen or water vapour from the atmosphere when the metallised reel is removed from the production machine and exposed to the atmosphere, and this causes its surface to oxidise, often in a somewhat unpredictable manner, and its surface resistivity to increase. Consequently, metallised aluminium susceptor films have to be manufactured with a lower surface resistivity than that ultimately required for optimum susceptor performance, and are then allowed to fade and stabilise at the required level. This "ageing" can take up to 2 months. In addition the very thin aluminium layer is easily damaged by handling (e.g. through scratching etc.) which can alter the surface resistivity and destroy its susceptor properties.
ii) During microwave heating, conventional susceptor films undergo non-reversible structural and electrical change. The distortion of the plastics film substrate produced by the heating produces discontinuities ("cracks") in the aluminium layer, increasing microwave transmission and impairing susceptor performance. In other circumstances, dangerous thermal run-away can occur leading in extreme cases to ignition of the material.
iii) Conventional susceptors have relatively poor barrier to oxygen and moisture, below that normally regarded as necessary for barrier packaging, and this precludes their use as combined susceptor and barrier packaging materials. If metal thickness is increased in order to improve barrier, microwave reflectivity also increases and no satisfactory compromise of microwave transmission, susceptor performance and barrier can be achieved.

There has been a long felt need to overcome the deleterious effects of susceptor break up, because of its adverse effect on both browning and general texture of the cooked foodstuff, and because of the risk, albeit remote, of ignition of the susceptor, and numerous attempts have been made to develop a susceptor which does not deteriorate in either its microwave reflectivity or browning performance in use, and is preferably self-limiting in the temperature it attains.

Early attempts utilised thin layers of ferromagnetic materials, both thin coatings of ferromagnetic metals themselves (such as stainless steel or chromium) or ferromagnetic compounds such as oxides. Such devices utilise both the magnetic and the electrical components of the microwave energy for heating, and ferromagnetic susceptors and their benefits are described in specifications such as US 2830162 and US 4266108. Whilst absorption of the electrical component of the microwave is highly dependent on maintaining the electrical continuity and surface resistivity of the coating, which must be relatively thin in order to achieve the required surface resistivity and is consequently highly sensitive to cracking, absorption of the magnetic component is less dependent on coating continuity. However, such ferromagnetic susceptors are significantly more expensive to manufacture, and their efficiency as microwave susceptors is limited by the relatively low magnetic loss factor of most ferromagnetic materials. Magnetic loss factor can be increased by increasing coating thickness, but this can increase microwave shielding and reduce rate of cooking of the bulk of the foodstuff.

Attempts have also been made to modify and improve performance of non-ferromagnetic susceptors. It is claimed that performance of conventional aluminium metallised susceptors can be enhanced by breaking up the continuous aluminium layer into a number of smaller individual "islands" of an appropriate size. This also allows control of microwave transmission through the material (via controlling the width of the clear microwave transparent channels between the islands), so that the susceptors can be tailored to the needs of cooking particular foodstuffs, browning only specific areas. Numerous techniques have been developed for the production of such "patterned" susceptors, and are described in specifications such as US 4230924 and EP-A-0282015. However, all appear to involve a post-treatment of a conventional metallised susceptor via a secondary process, such as etching away the aluminium with alkali, with consequent increased cost. Since the clear channels between the metal islands have no significant barrier, use of such materials as combined susceptor and barrier packaging materials is precluded.

An alternative adaptation of a non-ferromagnetic susceptor is the so-called "titanium oxide susceptor", described in US 5019681, which utilises the unique properties of certain heavy metal oxides, notably titanium sesquioxide (Ti₂O₃), which interact with the electrical component of microwaves but are less prone than conventional metal susceptors to non-reversible structural and electrical change. However, such oxide coatings have to be deposited by low rate processes such as sputtering, which is significantly more expensive than the high rate evaporation and condensation process used for manufacture of conventional aluminium susceptors.

It is known to produce materials with a combination of microwave susceptor and barrier properties by laminating a non-barrier conventional aluminium susceptor film to a microwave transparent clear barrier film or by laminating two aluminium metallised films, each with a surface resistivity higher than that required to give either microwave susceptor or barrier properties, and utilising the synergistic effect of the combination of these materials on barrier and microwave absorption (e.g. GB 2236278). However, such laminate susceptors are again expensive to produce and are not widely used.

High rate reactive evaporation processes have been described to produce flexible barrier films coated with barrier oxides such as the oxides of non-ferromagnetic metals like aluminium, or of non-metals like silicon (e.g. GB 2246794, EP-A-0437946 and related specifications). Such oxides, unlike the oxides of heavy metals such as titanium, are transparent to microwaves and therefore unsuitable as microwave susceptors. EP-A-0437946 discloses that if reactive evaporation of aluminium in oxygen is carried out using an excess of aluminium, the product is microwave interactive and the materials produce sparking of the metal and melting of the substrate when exposed to a microwave field.

We have now found that, surprisingly, and in contrast to previous teachings such as US 4267420, US 4641005, US 4230942 and EP 0282015 it is not necessary to deposit onto a plastics film substrate a continuous thin layer of non-ferromagnetic metal, which is capable of interacting with the electrical component of the microwave field, in order to produce a microwave susceptor. Rather, we have found that, by reactively evaporating a non-ferromagnetic metal, such as aluminium, in the presence of oxygen or an oxygen-containing species, according to the technique described in our European patent application 90313653.9 (EP-A-0437946), but using a slight excess of aluminium, just above that required to produce a microwave transparent barrier material, it is possible to produce. over a narrow range of stoichiometry, a material which shows microwave susceptor properties i.e. when laminated to paper or board and placed in a microwave field, it will heat up to a steady temperature.

According to the invention, there is provided the use of a coated barrier film to provide heating and browning of a surface of product adjacent the film, which film comprises a plastics film substrate laminated to paper or board, said plastics film substrate having a coating thereon comprising an essentially uniform mixture of a metallic element and an oxide of the metallic element, the amount of the metallic element distributed throughout the mixture being sufficiently greater than zero that, during microwaving, the coated film becomes heated to a stable temperature above 150°C, but below the melting point or other deterioration point of the coated film.

The barrier film may be made by a method which comprises subjecting a plastics film substrate to a reactive evaporation process wherein an oxygen-containing gas or vapour is introduced directly into a stream of evaporating metal to deposit on the film substrate a substantially uniform mixture of a metallic element and an oxide of the metallic element, the amount of the metallic element distributed throughout the mixture being sufficiently greater than zero that, during microwaving, the coated film becomes heated to a stable temperature above 150°C, but below the melting point or other deterioration point of the coated film and laminating the plastics film substrate to paper or board.

Suitably, the amount of metal deposited is such that the coating on the film has an optical density (after any fading) in the range 0.17 to 0.33, and most preferably in the range 0.21 to 0.24.

It is to be understood that by susceptor we mean a material which, during microwaving, becomes heated to a stable temperature (below its melting or other deterioration point) so as to provide reliable heating of a surface of a product adjacent the film.

The susceptor films used in the invention can have the following properties (compared to conventional susceptor films):
i) good barrier to oxygen and moisture;
ii) less easily damaged during manufacture e.g. by handling. The metal/metal oxide matrix can be much thicker than a metal layer alone, improving robustness;
iii) although surface resistivity increases non-reversibly when the material is placed in a microwave field, it continues to function effectively as a susceptor;
iv) less tendency to go into dangerous thermal run-away;
v) whereas with a conventional susceptor, the thin metal coating concentrates the heat energy at the film-metal interface, which can produce cracking of the substrate, with the metal/metal oxide matrix susceptor, there is less energy concentration and less risk of cracking.

The plastics films used in the invention can be any suitable thermally stable plastics film, such as those known and described in the art for production of microwave susceptor films. Polyester film is preferred, and if the material is to be used as a combined microwave susceptor and barrier material, it may be advantageous to use a heat sealable polyester film substrate in order to facilitate hermetic sealing of the pack.

The metal used may be any metal capable of absorbing the electrical component of a microwave field and converting it to heat, and which will readily oxidise in the reactive evaporation process. Non-ferromagnetic metals, particularly aluminium, which is low cost, easy to handle and readily oxidised, are preferred, but use of ferromagnetic metals which can interact with both the magnetic and electrical components of the microwave field is not precluded.

The oxidising gas used can be any gas which readily reacts with the chosen metal in the reactive evaporation process, with oxygen being preferred.The coat weight of metal/metal oxide mixture required to give acceptable microwave susceptor and barrier performance is relatively non-critical, and can be in the range 0.02 - 0.3 grams/metre², depending on the metal used and the foodstuff to be browned. For the preferred composition of aluminium/aluminium oxide, a coat weight of 0.03 - 0.05 grams/metre² appears to give optimum performance.

The most critical parameter in determining microwave susceptor performance is the stoichiometry of the metal/metal oxide matrix. With aluminium/aluminium oxide, usable susceptor performance can be obtained if the optical density (after any fading) is in the range 0.17 - 0.33 (this optical density excludes the contribution from the substrate). The range 0.21 - 0.24 is preferred, corresponding to a surface resistivity of approximately 100-200 ohms/square. However, optical density is only a general indicator of susceptor performance, and in practice the feasible optical density limits may have to be determined empirically, the limits of optical density being defined by the point at which the material ceases to have suitable usable susceptor properties, and the point at which the material ceases to have suitable usable microwave transmission. The optimum conditions are those which give the desired degree of browning for a particular product at the time its dielectric cooking is complete.

In order to produce a usable microwave susceptor, the metal/metal oxide coated film element is laminated to paper or board. If the material is to be used as a combined microwave susceptor and barrier packaging material e.g. for the production of a barrier pouch or barrier container, some suitable means of sealing the material to itself or to the other components of the pack will need to be built in either prior to coating with the metal/metal oxide matrix or in subsequent conversion, but this does not form part of the inventive step.

In order that the invention may be more fully understood, reference is made hereafter to the accompanying drawing, in which:

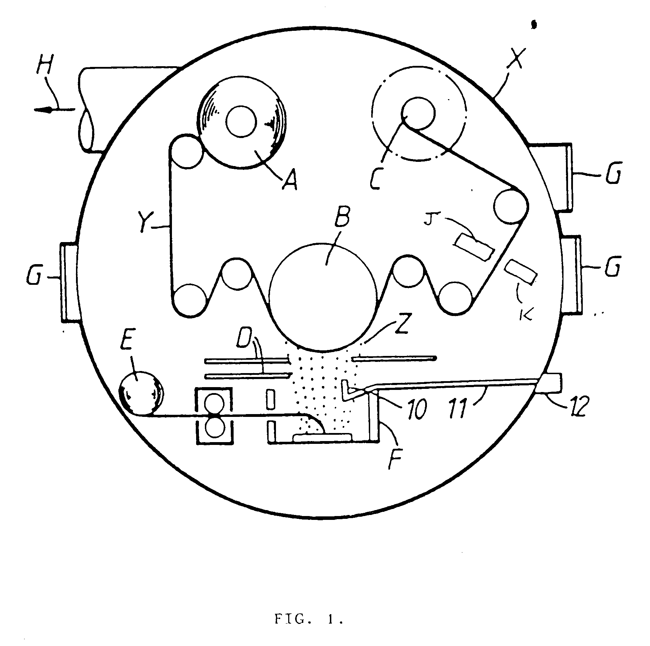

FIG. 1 is a diagrammatic representation of one form of apparatus suitable for making the susceptor materials used in the invention. The apparatus and its use are more fully described in EP-A-0437946.

Figure 1 is a diagrammatic representation of an apparatus which comprises a vacuum chamber X for depositing a layer of metal such as aluminium on one surface of a continuous web of plastic film. Within the chamber is a supply reel A from which film Y passes over a cooled drum B to take up reel C. An aperture and shutter assembly D controls the zone of evaporation of a metal supplied from a wire feed E to a ceramic heater block F maintained at a temperature above the evaporation temperature of the metal at the chamber pressure. The chamber is provided with an array of collimated light sources J across the width of the film and a corresponding array of photocells K so that the light transmission of the film can be measured after coating. The chamber is provided with viewing ports G and is connected at H to vacuum pumps. When used for conventional metallisation, vaporised metal from the heater flows in a zone of evaporation, indicated by broken lines Z, towards drum B and condenses on the film overlying the drum. A discharge nozzle 10 is connected by a pipe 11 to an inlet 12 for receiving a supply of a gas or vapour (not shown). The nozzle 10 is located either within the zone Z or between the heaters, and is directed in the direction of vapour flow from the heater to the drum. Several such assemblies may be mounted across the chamber to facilitate coating of wide films. The gas is introduced into the zone of vaporising metal. If the gas is merely introduced into the chamber outside this zone, this produced a pressure rise within the chamber causing unsatisfactory deposition and eventually the mean free path of the vaporised metal is so reduced that no deposition occurs.

The invention is illustrated by the following Example.

### Example

A reel of 12 micrometres polyester film (commercially available as Hostaphan RP ex Hoechst AG) was coated with an aluminium/aluminium oxide mixture via the reactive evaporation process described in EP-A-0437946. Optical density of the aluminium coated polyester film was 0.88 - 0.90 prior to introduction of oxygen. Oxygen was introduced to reduce optical density to 0.39 - 0.41. On removing the coated film from the chamber, optical density decreased and stabilised after 4-5 days at 0.25 - 0.28. Oxygen permeability of the resultant film was 1.5 - 2.5 cm³/metre²/24 hours (at 23°C, 50% RH) and its moisture vapour transmission rate (MVTR) was 0.6 - 0.9 grams (at 38°C, 90% RH). The coated side of the film was laminated to a 135 gsm cartridge paper using a commercially available water based polyvinyl acetate emulsion adhesive. A 5 inch (12.7cm) round sample of this laminate was mounted on a similarly sized single faced B flute corrugated pad manufactured from 40 gsm machine glazed bleached Kraft paper, with the flutes facing downwards (this technique, which improves the insulation of the pad, is known and taught in US 4190757).

Four fluoroptic probes of a Luxtron 755 thermometer were attached to the pad at 15 mm intervals in from the edge, to measure temperature rise during microwaving. A 5 inch (12.7cm) diameter, 80 gram pizza, previously defrosted to ambient temperature (22°C) was placed on the pad. This assembly was placed on the turntable of a 650 watt domestic microwave oven. The oven was also fitted with a further counter rotating turntable under the turntable carrying the assembly. The first turntable overcame the usual hot spot problems associated with static microwaving, and the second maintained the assembly stationery in relation to the environment.

The oven was switched on for a 2½ minute cycle, and temperature rise monitored. A rapid rise to about 110°C occurred in the first few seconds, followed by a more steady rise to a final temperature of about 160°C after 2½ minutes. Repeat tests with further similarly constructed pads confirmed reproducibility.

A control sample was prepared in a similar way using a conventional aluminium metallised polyester susceptor film with an optical density of 0.22. This film had an oxygen permeability of 15 - 30 cm³/metre²/24 hours (at 23°C, 50%RH) and an MVTR of 10 - 20 grams/metre²/24 hours (at 38°C, 90% RH).

Comparison of microwaving results with the two materials showed that the aluminium/aluminium oxide matrix susceptor gave an improved and more consistent performance than the conventional aluminium metallised susceptor, with less tendency to go into thermal run-away.

## Claims

1. The use of a coated barrier film to provide heating and browning of a surface of product adjacent the film, which film comprises a plastics film substrate laminated to paper or board, said plastics film substrate having a coating thereon comprising an essentially uniform mixture of a metallic element and an oxide of the metallic element, the amount of the metallic element distributed throughout the mixture being sufficiently greater than zero that, during microwaving, the coated film becomes heated to a stable temperature above 150°C, but below the melting point or other deterioration point of the coated film.

2. The use according to claim 1, wherein the plastics film is poly(ethylene glycol)terephthalate.

3. The use according to claim 1 or 2, wherein the metal is a non-ferromagnetic metal such as aluminium.

## Patentansprüche

1. Verwendung einer beschichteten Sperrfolie zum Erhitzen und Bräunen einer an die Folie angrenzenden Oberfläche eines Produkts, wobei die Folie ein auf Papier oder Pappe laminiertes Kunststoffoliensubstrat umfaßt, wobei sich auf dem Kunststoffoliensubstrat eine Beschichtung befindet, die eine im wesentlichen einheitliche Mischung aus einem Metallelement und einem Oxid des Metallelementes umfaßt, wobei die Menge des in der Mischung verteilten Metallelementes ausreichend großer als Null ist, so daß während der Einwirkung von Mikrowellen die beschichtete Folie auf eine stabile Temperatur über 150°C, aber unter dem Schmelzpunkt oder anderen Zersetzungspunkt der beschichteten Folie erhitzt wird.

2. Verwendung nach Anspruch 1, worin die Kunststoffolie aus Poly(ethylen-glycol)terephthalat ist.

3. Verwendung nach Anspruch 1 oder 2, worin das Metall ein nichtferromagnetisches Metall wie Aluminium ist.

## Revendications

1. Utilisation d'un film barrière revêtu pour permettre le chauffage et le brunissage d'une surface de produit adjacente au film, lequel film comprend un substrat de film plastique stratifié sur du papier ou du carton, ledit substrat de film plastique comportant un revêtement comprenant un mélange sensiblement uniforme d'un élément métallique et d'un oxyde de l'élément métallique, la quantité de l'élément métallique distribuée dans le mélange étant suffisamment supérieure à zéro pour que, pendant l'application de micro-ondes, le film revêtu soit chauffé à une température stable supérieure à 150°C mais inférieure au point de fusion ou à un autre point de détérioration du film revêtu.

2. Utilisation selon la revendication 1, dans laquelle le film plastique est du poly(téréphtalate d'éthylèneglycol).

3. Utilisation selon la revendication 1 ou 2, dans laquelle le métal est un métal non ferromagnétique tel que l'aluminium.
